# EUROPEAN PATENT APPLICATION

(11) **EP 4 401 137 A1**
(43) Date of publication of application: **17.07.2024**
(21) Application number: 23192846.6
(22) Date of filing: 23.08.2023
(51) Int. Cl.: H01L 27/02, H02H 9/04

(54) **STRUCTURE INCLUDING N-TYPE WELL OVER N-TYPE DEEP WELL AND BETWEEN PAIR OF P-TYPE WELLS FOR ESD PROTECTION**

(30) Priority: 10.01.2023 US 202318152420
(71) Applicant: GlobalFoundries U.S. Inc., Malta, NY 12020 (US)
(72) Inventor: Karalkar, Sagar Premnath, Essex Junction, 05452 (US); Gebreselasie, Ephrem G., Essex Junction, 05452 (US); Krishnasamy, Rajendran, Essex Junction, 05452 (US); Gauthier, Robert J., Williston, 05495 (US); Mitra, Souvick, Essex Junction, 05452 (US)
(74) Representative: Grünecker Patent- und Rechtsanwälte PartG mbB

(57) **Abstract**

The disclosure provides a structure including an n-type well over an n-type deep well and between a pair of p-type wells for electrostatic discharge (ESD) protection. The structure may include a p-type deep well over a substrate, a first n-type well over the p-type deep well, and a pair of p-type wells over the p-type deep well. The pair of p-type wells are each adjacent opposite horizontal ends of the n-type well. A pair of second n-type wells are over the p-type deep well and adjacent one of the pair of p-type wells. Each p-type well is horizontally between the first n-type well and one of the second n-type wells.

## Description

### BACKGROUND

### 1. TECHNICAL FIELD

The present disclosure provides integrated circuit structures with an n-type well over an n-type deep well and between a pair of p-type wells for electrostatic discharge (ESD) protection.

### 2. BACKGROUND ART

Present technology is at atomic level scaling of certain micro-devices such as logic gates, bipolar transistors, field effect transistors (FETs), and capacitors. Circuit chips with millions of such devices are common. Some devices for routing excess current away from sensitive components, e.g., electrostatic discharge (ESD) devices, are designed to be electrically active only in specific operating circumstances. Such devices are conventionally structured to trigger in response to voltage magnitude of a predetermined polarity, i.e., they may only support flow of current in one direction and hence cannot simultaneously accommodate ESD events producing positive and negative voltage biases. In conventional integrated circuit layouts, two ESD devices must be provided to protect against ESD events that produce excessive positive or negative voltages. Providing additional ESD devices in one product thus requires additional surface area and may contribute to leakage current and/or voltage during non-ESD operation.

### SUMMARY

The illustrative aspects of the present disclosure are designed to solve the problems herein described and/or other problems not discussed.

Embodiments of the disclosure provide a structure including: a p-type deep well over a substrate; a first n-type well over the p-type deep well; a pair of p-type wells over the p-type deep well and adjacent opposite horizontal ends of the first n-type well; and a pair of second n-type wells over the p-type deep well and each adjacent one of the pair of p-type wells, such that each p-type well is horizontally between the first n-type well and one of the second n-type wells.

Further embodiments of the disclosure provide a structure including: a first semiconductor-controlled rectifier (SCR) over a substrate, the first SCR including a first set of alternatingly doped wells to define a first N-P-N junction over the substrate, wherein the first set of alternatingly doped wells includes a first n-type well within a floating well region, a second n-type well coupled to ground, and a first p-type well therebetween; and a second SCR over the substrate, the second SCR including a second set of alternatingly doped wells to define a second N-P-N junction over the substrate, wherein the second set of alternatingly doped wells includes the first n-type well within the floating well region, a third n-type well coupled to a voltage supply, and a second p-type well therebetween, such that the first n-type well is shared between the first SCR and the second SCR.

Additional embodiments of the disclosure provide a structure including: an n-type deep well over a substrate; a p-type deep well over the n-type deep well; a first n-type well over the p-type deep well; a P+ terminal on the first n-type well and coupled to an input/output (I/O) node, a pair of p-type wells over the p-type deep well and adjacent opposite horizontal ends of the first n-type well; a pair of second n-type wells over the p-type deep well and each adjacent one of the pair of p-type wells, such that each p-type well is horizontally between the first n-type well and one of the second n-type wells; a first N+ terminal on one of the pair of second n-type wells and coupled to ground; and a second N+ terminal on the other of the pair of second n-type wells and coupled to a voltage supply, wherein the deep p-type well, the deep n-type well, the first n-type well, and the pair of p-type wells each define floating semiconductor regions within the structure.

### BRIEF DESCRIPTION OF THE DRAWINGS

These and other features of this disclosure will be more readily understood from the following detailed description of the various aspects of the disclosure taken in conjunction with the accompanying drawings that depict various embodiments of the disclosure, in which:
FIGS. 1 and 2 depict cross-sectional views of a structure according to embodiments of the disclosure.
FIG. 3 depicts a plan view of a structure according to further embodiments of the disclosure.
FIGS. 4 and 5 depict cross-sectional views of the structure according to further embodiments of the disclosure.
FIG. 6 depicts a schematic diagram of an equivalent circuit for the structure according to embodiments of the disclosure.

It is noted that the drawings of the disclosure are not necessarily to scale. The drawings are intended to depict only typical aspects of the disclosure, and therefore should not be considered as limiting the scope of the disclosure. In the drawings, like numbering represents like elements between the drawings.

### DETAILED DESCRIPTION

The corresponding structures, materials, acts, and equivalents of all means or step plus function elements in the claims below are intended to include any structure, material, or act for performing the function in combination with other claimed elements as specifically claimed. The description of the present disclosure has been presented for purposes of illustration and description but is not intended to be exhaustive or limited to the disclosure in the form disclosed. Many modifications and variations will be apparent to those of ordinary skill in the art without departing from the scope and spirit of the disclosure. The embodiment was chosen and described to best explain the principles of the disclosure and the practical application, and to enable others of ordinary skill in the art to understand the disclosure for various embodiments with various modifications as are suited to the particular use contemplated.

The disclosure provides a structure including an n-type well over an n-type deep well and between a pair of p-type wells for electrostatic discharge (ESD) protection. The structure may include a p-type deep well over a substrate, a first n-type well over the p-type deep well, and a pair of p-type wells over the p-type deep well. The pair of p-type wells are each adjacent opposite horizontal ends of the n-type well. A pair of second n-type wells are over the p-type deep well and adjacent one of the pair of p-type wells. Each p-type well is horizontally between the first n-type well and one of the second n-type wells. Among other benefits, structures of the disclosure offer a "bi-directional" device capable of being triggered under sufficient positive or negative voltage biasing.

IC structures according to the disclosure may operate using multiple "P-N junctions." The term "P-N" refers to two adjacent materials having different types of conductivity (i.e., P-type and N-type), which may be induced through dopants within the adjacent material(s). A P-N junction, when formed in a device, may operate as a diode. A diode is a two-terminal element, which behaves differently from conductive or insulative materials between two points of electrical contact. Specifically, a diode provides high conductivity from one contact to the other in one voltage bias direction (i.e., the "forward" direction), but provides little to no conductivity in the opposite direction (i.e., the "reverse" direction).

In the case of the P-N junction, the orientation of a diode's forward and reverse directions may be contingent on the type and magnitude of bias applied to the material composition of one or both terminals, which affect the size of the potential barrier. In the case of a junction between two semiconductor materials, the potential barrier will be formed along the interface between the two semiconductor materials. Three adjacent materials having respective voltage polarities may be combined to form a pair of diodes, thus providing a "P-N-P" structure in which each of the pair of diodes is defined between the n-doped material and one of two regions of p-doped material.

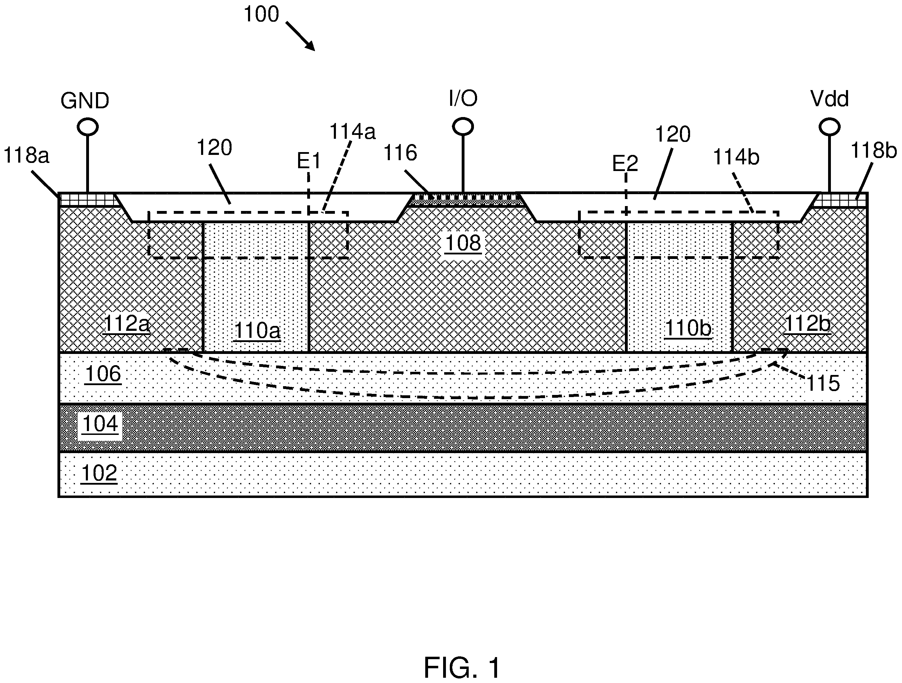

Referring to FIG. 1, an integrated circuit (IC) structure (simply "structure" hereafter) 100, according to embodiments of the disclosure, is shown. Structure 100 is formed on a substrate 102 including, e.g., one or more semiconductor materials. Substrate 102 may include but is not limited to silicon, germanium, silicon germanium (SiGe), silicon carbide, or any other common integrated circuit (IC) semiconductor substrates. In the case of SiGe, the germanium concentration in substrate 102 may differ from other SiGe-based structures described herein. A portion or entirety of substrate 102 may be strained.

Structure 100 may include a various materials, e.g., various deep and shallow wells, doped semiconductor materials, trench isolation regions, etc., over substrate 102. A deep n-well 104 may be on substrate 102 and may extend horizontally throughout substrate 102, and/or may be formed selectively under locations where doped materials are formed, examples of which are discussed elsewhere herein. Deep n-well 104 may include the same or similar material(s) present in substrate 102 but may include a higher concentration of dopants therein. In an example implementation, deep n-well 104 may be doped n-type. Structure 100 also may include a deep p-well 106 on deep n-well 104. Deep p-well 106 may be substantially similar in size and thickness to deep n-well 104 but may have an opposite doping type such that a P-N junction is present between deep wells 104, 106. During manufacture, deep wells 104, 106 initially may be part of substrate 102 before being doped to a respective polarity and/or concentration, and thus structurally distinguished from substrate 102.

Various conductive particles ("dopants") may be introduced into deep wells 104, 106 above substrate 102. A "dopant" refers to an element introduced into semiconductor to establish either p-type (acceptors) or n-type (donors) conductivity. In the case of a silicon substrate, common dopants may include, e.g., boron (B), and/or indium (In), for p-type doping (i.e., for deep p-well 106). For n-type doping, the doped element(s) may include, for example, phosphorous (P) arsenic (As), and/or antimony (Sb) (i.e., for deep n-well 104). Doping is the process of introducing impurities (dopants) into the semiconductor substrate, or elements formed on the semiconductor substrate, and is often performed with a mask (e.g., a film of photoresist material and/or other component to block dopants) in place so that only certain areas of the substrate will be doped. In the example of doping by implantation, an ion implanter may be employed. In further examples, in-situ doping or other doping techniques may be used.

In doping processes, a doping type, a dopant species, a dosage, and an energy level are specified and/or a resulting doping level may be specified. A dosage may be specified in the number of atoms per square centimeter (cm²) and an energy level (specified in keV, kilo-electron-volts), resulting in a doping level (concentration in the substrate) of a number of atoms per cubic centimeter (cm³). The number of atoms is commonly specified in exponential notation, where a number like "3E15" means 3 times 10 to the 15th power, or a "3" followed by 15 zeroes (3,000,000,000,000,000). An example of doping is implanting with B (boron) with a dosage of between about 1E12 and 1E13 atoms/cm², and an energy of about 40 to 80 keV to produce a doping level of between 1E17 and 1E18 atoms/cm³.

As noted herein, doped portions of a substrate may be known in the art as a "well." A well commonly refers to the implanted/diffused region in semiconductor wafer needed to implement a complementary metal oxide semiconductor (CMOS) cell. A "deep well" (e.g., deep p-well 104 and deep n-well 106 discussed herein) refers to doped semiconductor material located underneath active device components and/or other wells. A "shallow well," similar to a deep well, is an area of doped semiconductor material located beneath active device components but not to the same depth as a deep well. Various additional components may be formed on deep n-well 106. It is possible for a highly doped active semiconductor material to be located inside of a shallow well or deep well, and/or for the shallow well in turn to be located inside of a deep well. Depending on the attributes of a device to be manufactured, portions of semiconductor material on or over substrate 102 and deep wells 104, 106 may be either n-type or p-type doped as discussed herein.

Embodiments of structure 100 are operable to provide multiple P-N-P semiconductor junctions, each having a respective polarity by having a respectively biased terminal coupled thereto, to protect against ESD events inducing a positive or negative voltage of a magnitude exceeding a threshold voltage. The two P-N-P semiconductor junctions of structure 100 each may be defined in portions of a first n-type well 108 that is located over deep n-well 106, i.e., the upper surface of deep n-well 106 may border the lower surface of first p-type well 108. First n-type well 108, as well as other components discussed herein, may be considered to be a "floating" doped semiconductor region within structure 100. The term "floating" in this context, does not imply any physical position of the material relative to other materials. Rather, "floating" in the case of a doped semiconductor material means that the material is not electrically coupled to a predetermined voltage bias, i.e., its voltage level at a given time during operation depends at least partially on the voltage level of other materials coupled thereto. As shown in FIG. 1 and discussed elsewhere herein, first n-type well 108 is considered "floating" because it has an oppositely doped terminal thereover and does not include any electrical connection to a predetermined voltage supply or other biasing component.

Structure 100 additionally may include a pair of p-type wells 110 (separately labeled as 110a to the left of first n-type well 108 and 110b to the right of first n-type well 108), each located over deep p-type well 106 and adjacent a respective horizontal end E1, E2 of first n-type well 108. The presence of p-type wells 110 adjacent each horizontal end E1, E2 of first n-type well 108 forms a respective pair of P-N junctions over deep p-well 106. To provide a third P-type material to provide P-N-P triode junction couplings (and hence, semiconductor controlled rectifiers (SCRs) as discussed herein) to first n-type well 108, structure 100 may include a pair of second n-type wells 112 (separately identified as 112a, 112b for ease of description), each adjacent one p-type well 110a, 110b. Thus, p-type well 110a may be horizontally between first n-type well 108 and second n-type well 112a, whereas p-type well 110b may be horizontally between first n-type well 108 and second n-type well 112b. Deep p-type well 106 vertically separates deep n-type well 104 from first n-type well 108, p-type wells 110a, 110b, and second n-type wells 112a, 112b.

Structure 100 includes two semiconductor controlled rectifiers (SCRs) 114 (separately identified as 114a, 114b for sake of explanation), each defined partially within first n-type well 108. SCRs 114a, 114b each exhibit a substantially non-conductive under low-magnitude operating voltage but will become conductive when an ESD event or other situation causes at least a threshold voltage to be applied to the I/O node of structure 100. As discussed elsewhere herein, one SCR 114 (e.g., SCR 114a) may become conductive in response to negative voltages of at least a threshold magnitude, whereas the other SCR 114 (e.g., SCR 114b) may become conductive in response to positive voltages (i.e., the opposite polarity of voltage) of at least the threshold magnitude. Deep p-type well 106 therefore also vertically separates deep n-type well 104 from each SCR 114a, 114b. In addition to SCRs 114a, 114b, structure 100 may include a bipolar N-P-N junction 115 from a voltage supply (Vdd) to ground (GND) between second n-type wells 112a, 112b through deep p-well 106.

Structure 100 may include additional components to define operative couplings to other portions of a device, e.g., terminals set to a predetermined voltage level and/or terminals having the same voltage as operative components of the device. A P+ terminal 116, i.e., a region of semiconductor material having a significantly higher concentration of p-type dopants than other p-type semiconductor regions or wells discussed herein, may be on first n-type well 108. P+ semiconductor material may have a significantly greater impurity ratio (i.e., ratio of impurity atoms relative to pure atoms), e.g., at least approximately one to ten thousand. P-type semiconductor materials that are not "P+" doped materials may have an impurity ratio that is less than approximately one to ten thousand. P+ terminal 116, for instance, may have a lower surface which physically interfaces with the upper surface of first n-type well 108. In this configuration, P+ terminal 116 defines a P-N junction with first n-type well 108 such that the voltage level of P+ terminal 116 does not directly define the voltage bias within first n-type well 108. An input/output (I/O) terminal may be coupled to P+ terminal 116 for coupling of structure 100 to operative components of a device or circuit to be protected using structure 100. Under non-ESD operating conditions, the P-N junction between P+ terminal 116 and first n-type well 108 may substantially prevent any current from flowing from P+ terminal 116 into other portions of structure 100 (i.e., the P-N junction between first n-type well 108 and P+ terminal 116 is oriented against the flow of current from the I/O terminal).

Structure 100 also may include a set of N+ terminals 118 each over one n-type well 112, e.g., a first N+ terminal 118a may be over one corresponding second n-type well 112a, and a second N+ terminal 118b may be over the other second n-type well 112b. Similar to P+ semiconductor materials discussed herein, an "N+" semiconductor material such as N+ terminals 118a, 118b may have an impurity ratio that is at least approximately ten thousand. Unlike P+ terminal 116, each N+ terminal 118a, 118b may be of the same doping polarity as second n-type well 112a, 112b thereunder (i.e., no P-N junction is defined between these components). First N+ terminal 118a may be coupled to ground GND, whereas second N+ terminal 118b may be coupled to voltage supply Vdd to define two voltage levels. Voltage supply Vdd may be of a greater magnitude than the specified operating voltage(s) transmitted to the I/O terminal, whereas ground GND indicates a zero voltage. SCRs 114a, 114b thus define alternate current pathways from ESD-induced currents to pass through structure 100, depending on whether the ESD event induces a positive voltage or negative voltage at P+ terminal 116 via the I/O terminal.

Structure 100 may include a group of isolation regions 120 (e.g., shallow trench isolations, known as "STIs") to electrically separate the P+ terminal 116 from N+ terminals 118a, 118b. Isolation regions 120 may be composed of any insulating material such as an oxide, e.g., SiO₂. Other materials appropriate for the composition of isolation regions 120 may include, for example, borophosphosilicate glass (BPSG), spin-on glass and/or spin-on polymers, other insulators having an effective dielectric constant of less than approximately 3.9, and/or other currently known or later-developed materials having similar properties. Isolation regions 120 may be formed, e.g., by partially recessing portions of wells 108, 110a, 110b, 112a, 112b where isolation regions 120 are desired, forming insulative material within the recessed areas, and planarizing the insulative material such that its upper surface is substantially coplanar with adjacent doped semiconductor material(s) (e.g., terminals 116, 118a, 118b).

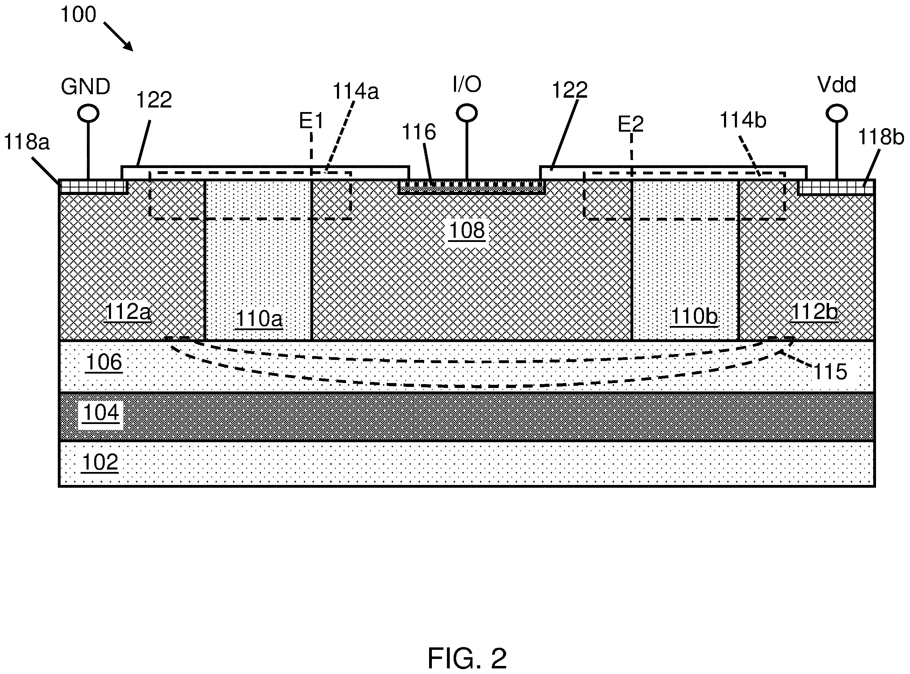

Turning briefly to FIG. 2, further implementations of structure 100 may electrically isolate terminals 116, 118a, 118b from each other without the use of isolation region(s) 120 (FIG. 1). In such a configuration, a set of silicide blocking layers 122 (e.g., any currently known or later developed insulative material(s), such as silicon dioxide (SiO₂) configured to prevent growth of silicide and/or other conductors thereon may be provided as portions of each terminal 116, 118a, 118b and wells 108, 110a, 110b, 112a, 112b therebetween. Where applicable, silicide blocking layers 122 may allow terminals 116, 118a, 118b to be isolated from each other without any need to recess any portion of wells 108, 110a, 110b, 112a, 112b and form insulative materials (e.g., isolation region(s) 120) therein. In further implementations, a mixture of isolation region(s) 120, silicide blocking layers 122, and/or other currently known or later developed insulative structures and/or compositions may be used in place of one or more isolation region(s) 120 and/or silicide blocking layers 122.

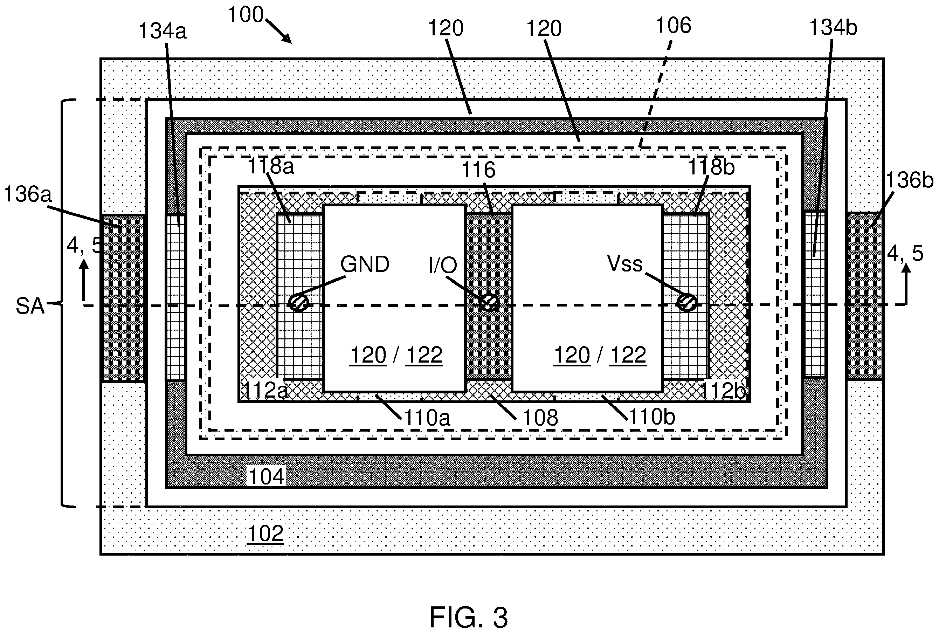

Referring to FIG. 3, a plan view of a structure 100 according to further implementations of the disclosure is shown. Structure 100 may be sized and structured for placement within a predetermined surface area SA of substrate 102 in any conceivable geometry, e.g., a quadrilateral shape in two dimensions as shown. Structure 100, alternatively, may be in any other geometrical configuration to enclose surface area SA of substrate 102. Additionally, structurally foundational semiconductor materials (i.e., substrate 102, deep wells 104, 106 thereover) may extend laterally beyond the lateral edges of overlying materials to improve manufacturability and/or create space where additional electrical contacts may be formed to substrate 102, and/or deep wells 104, 106. Thus, deep n-well 104 may be shaped as a scyphoid (i.e., a cup shape) such that outer portions of deep n-well 104 surround deep p-well 106, and inner portions of deep n-well 104 are vertically beneath lower surfaces of deep p-well 106. Portions of substrate 102 within structure 100 may also be in the shape of a scyphoid. Similar to deep n-well 104, inner portions of substrate 102 may be vertically below deep n-well 104 but outer portions of substrate 102 may horizontally surround deep n-well 104 and subcomponents located therein. To electrically insulate horizontally adjacent doped materials from each other, structure 100 may include additional isolation region(s) 120 or other insulative materials (e.g., silicide blocking layers 122 discussed herein), e.g., horizontally between substrate 102 and deep n-well 104, and horizontally between deep wells 104, 106. In this configuration, substrate 102 and deep wells 104, 106 may be independently biased or may remain floating as discussed herein.

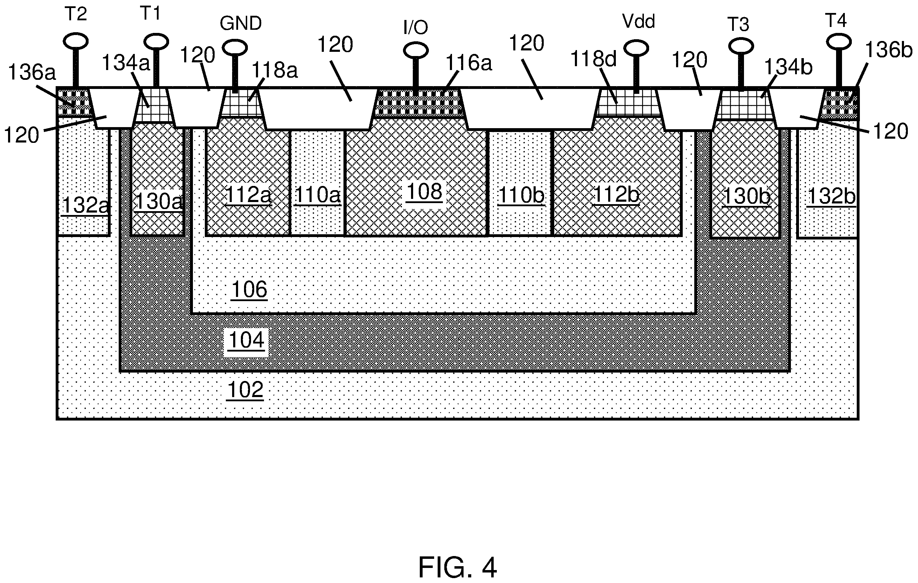

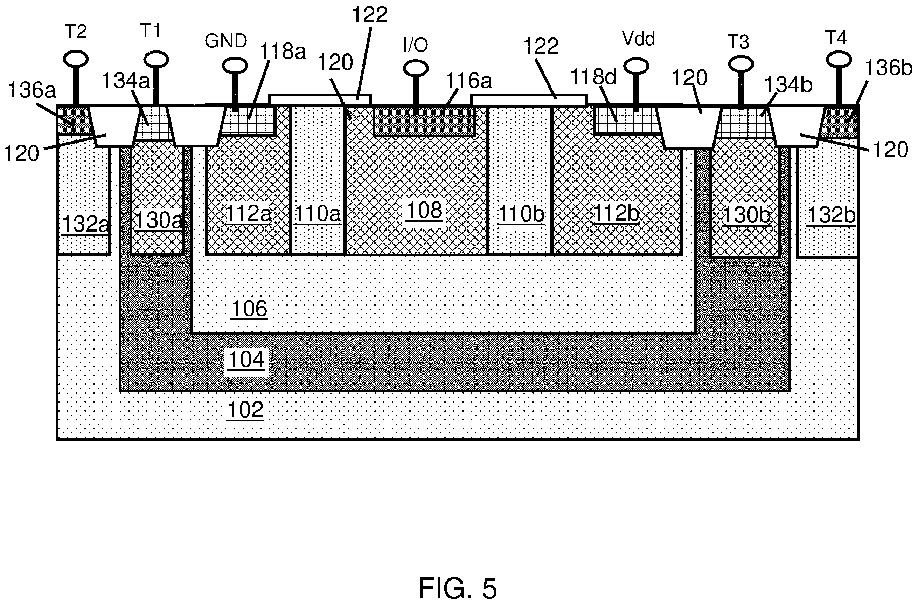

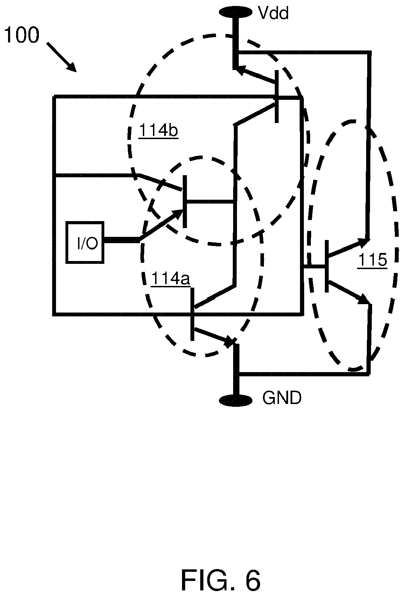

Referring now to FIGS. 4 and 5, cross-sectional views taken from view lines 4-4, 5-5 in FIG. 3 depict additional features of structure 100. More specifically, substrate 102 and/or deep n-well 104 may be configured for electrical biasing and/or coupling to other structures that are external to structure 100. In this case, the upper portion(s) of deep n-well 104 may include a set of n-type wells 130a, 130b (collectively 130) that are horizontally distal to, and hence decoupled from, deep p-well 106. The upper portion(s) of substrate 102 similarly may include a set of p-type wells 132a, 132b (collectively 132) that are horizontally distal to deep n-well 104. Similar to wells 108, 112a, 112b discussed herein, n-type wells 130a, 130b each may have an n-type terminal 134a, 134b therein and p-type wells 132a, 132b each may have a p-type terminal 136a, 136b therein. Each terminal 134a, 134b, 136a, 136b may define or otherwise be coupled to a respective electrical coupling (T1, T2, T3, T4) for connecting other elements, components, etc., to substrate 102 or deep n-well 104, and/or for electrical biasing of these components. Each overlying contact (indicated via GND, I/O, and Vss) to terminal(s) 134a, 134b, 136a, 136b may be partially on the doped semiconductor material of each terminal 134a, 134b, 136a, 136b, but optionally may entirely cover the doped semiconductor material(s) in other implementations. Electrical couplings T1 and T3 may be connected together and set to a higher voltage (or to supply voltage Vdd), whereas electrical couplings T2, T4 may be grounded and/or set to the voltage level of substrate 102. Similar to other embodiments discussed herein, isolation region(s) 120 (FIG. 5), silicide blocking layers 122 (FIG. 6), and/or insulative materials may be horizontally between terminals 134a, 134b, 136a, 136b and other components of structure 100 to prevent electrical shorting from one coupling T1, T2, T3, T4 to another.

Referring to FIGS. 1 and 6 together, FIG. 6 depicts an equivalent circuit implemented through embodiments of structure 100 discussed herein. Each SCR 114a, 114b and bipolar N-P-N junction 115 define equivalent current-controlled devices (illustrated as bipolar transistors) configured to prevent current flow from one terminal to another. A threshold current being applied to the base (i.e., P-type region) of each SCR to the I/O terminal from an ESD event, enables current flow through SCRs 114a, 114b and N-P-N junction 115 from the I/O terminal to voltage supply Vdd or ground GND. In this configuration, the equivalent circuit implemented by structure 100 is operable to enable current flow from high voltages triggered by high voltages or low voltages, and without requiring independent circuits to accommodate each voltage polarity. Such features are enabled, in part, by first n-type well 108 and p-type wells 110a, 110b being floating (i.e., not directly biased) materials and thus capable of transmitting current under different voltage polarities.

Embodiments of the disclosure provide various commercial and technical advantages, examples of which are discussed herein. Embodiments of structure 100 may be a single ESD-protective device that is capable of being triggered by sufficiently high positive or negative voltages, despite being of similar size to ESD-protective devices which accommodate only positive or negative voltages. These and other benefits may arise from using a set of floating wells (i.e., first n-type well 108 and p-type wells 110a, 110b) to create two P-N-P junctions (i.e., SCRs 114a, 114b) in which one p-type material is shared between the two P-N-P junctions. These and other benefits can be realized without additional masks when fabricating embodiments of structure 100, e.g., because the additional floating doped semiconductor materials within wells 108a, 110a, 110b can be formed by increasing or modifying the doping process(es) implemented on conventional precursor materials (i.e., a conventional configuration of substrate 102).

The method and structure as described above are used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher-level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a center processor.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. "Optional" or "optionally" means that the subsequently described event or circumstance may or may not occur, and that the description includes instances where the event occurs and instances where it does not.

Approximating language, as used herein throughout the specification and claims, may be applied to modify any quantitative representation that could permissibly vary without resulting in a change in the basic function to which it is related. Accordingly, a value modified by a term or terms, such as "about," "approximately," and "substantially," are not to be limited to the precise value specified. In at least some instances, the approximating language may correspond to the precision of an instrument for measuring the value. Here and throughout the specification and claims, range limitations may be combined and/or interchanged, such ranges are identified and include all the sub-ranges contained therein unless context or language indicates otherwise. "Approximately" as applied to a particular value of a range applies to both values, and unless otherwise dependent on the precision of the instrument measuring the value, may indicate +/- 10% of the stated value(s).

The corresponding structures, materials, acts, and equivalents of all means or step plus function elements in the claims below are intended to include any structure, material, or act for performing the function in combination with other claimed elements as specifically claimed. The description of the present disclosure has been presented for purposes of illustration and description but is not intended to be exhaustive or limited to the disclosure in the form disclosed. Many modifications and variations will be apparent to those of ordinary skill in the art without departing from the scope and spirit of the disclosure. The embodiment was chosen and described in order to best explain the principles of the disclosure and the practical application, and to enable others of ordinary skill in the art to understand the disclosure for various embodiments with various modifications as are suited to the particular use contemplated.

In summary, the following embodiments are explicitly disclosed.

### Embodiment 1:

A structure comprising: a p-type deep well over a substrate; a first n-type well over the p-type deep well; a pair of p-type wells over the p-type deep well and adjacent opposite horizontal ends of the first n-type well; and a pair of second n-type wells over the p-type deep well and each adjacent one of the pair of p-type wells, such that each p-type well is horizontally between the first n-type well and one of the second n-type wells.

### Embodiment 2:

The structure of embodiment 1, further comprising a P+ terminal on the first n-type well, the P+ terminal being coupled to an input/output (I/O) terminal, wherein the first n-type well defines a floating well beneath the P+ terminal.

### Embodiment 3:

The structure of embodiment 2, further comprising a pair of trench isolation (TI) regions each over a corresponding one of the pair of p-type wells, wherein the P+ terminal is horizontally between the pair of isolation regions.

### Embodiment 4:

The structure of embodiment 2 or 3, further comprising a first N+ terminal coupled to ground and on one of the pair of second n-type wells and a second N+ terminal coupled to a voltage supply and on the other of the pair of second n-type wells.

### Embodiment 5:

The structure of embodiment 4, wherein a current pathway between the I/O terminal and the first N+ terminal defines a first semiconductor controlled rectifier (SCR), and a current pathway between the I/O terminal and the second N+ terminal defines a second SCR, and the first n-type well is shared between the first SCR and the second SCR.

### Embodiment 6:

The structure of one of embodiments 1 to 5, wherein the n-type well and pair of p-type wells define floating semiconductor regions within the structure.

### Embodiment 7:

The structure of one of embodiments 1 to 6, further comprising a deep n-type well below the deep p-type well, wherein the deep p-type well vertically separates the deep n-type well from the first n-type well, the pair of p-type wells, and the pair of second n-type wells.

### Embodiment 8:

The structure of embodiment 7, wherein the deep p-type well and the deep n-type well each define floating semiconductor regions within the structure.

### Embodiment 9:

The structure of one of embodiments 1 to 8, comprising a first semiconductor-controlled rectifier (SCR) and a second SCR, each being formed over the substrate, wherein the pair of p-type wells comprises a first p-type well and a second p-type well, wherein the pair of second n-type wells comprises a second n-type well and a third n-type well, wherein the first SCR comprises a first set of alternatingly doped wells to define a first N-P-N junction over the substrate, wherein the first set of alternatingly doped wells comprises the first n-type well within a floating well region, the second n-type well coupled to ground, and the first p-type well therebetween, and wherein the second SCR comprises a second set of alternatingly doped wells to define a second N-P-N junction over the substrate, wherein the second set of alternatingly doped wells comprises the first n-type well within the floating well region, the third n-type well coupled to a voltage supply, and the second p-type well therebetween, wherein the first n-type well is shared between the first SCR and the second SCR. In other words, the structure of one of embodiments 1 to 8 is provided such that the first and second SCRs are formed over the substrate.

### Embodiment 10:

A structure including: a first semiconductor-controlled rectifier (SCR) over a substrate, the first SCR including a first set of alternatingly doped wells to define a first N-P-N junction over the substrate, wherein the first set of alternatingly doped wells includes a first n-type well within a floating well region, a second n-type well coupled to ground, and a first p-type well therebetween; and a second SCR over the substrate, the second SCR including a second set of alternatingly doped wells to define a second N-P-N junction over the substrate, wherein the second set of alternatingly doped wells includes the first n-type well within the floating well region, a third n-type well coupled to a voltage supply, and a second p-type well therebetween, such that the first n-type well is shared between the first SCR and the second SCR.

### Embodiment 11:

The structure of embodiment 9 or 10, further comprising a P+ terminal on the first n-type well, the P+ terminal being coupled to an input/output (I/O) terminal.

### Embodiment 12:

The structure of embodiment 11, further comprising a pair of trench isolation (TI) regions each over a corresponding one of the first p-type well or the second p-type well, wherein the P+ terminal is horizontally between the pair of isolation regions.

### Embodiment 13:

The structure of embodiment 11 or 12, wherein the second n-type well is coupled to ground through a first N+ terminal over the second n-type well, and wherein the third n-type well is coupled to the voltage supply through a second N+ terminal over the third n-type well.

### Embodiment 14:

The structure of one of embodiments 9 to 13, wherein the first p-type well and the second p-type well define floating semiconductor regions within the structure.

### Embodiment 15:

The structure of one of embodiments 9 to 14, further comprising: a deep p-type well below the first SCR and the second SCR; and a deep n-type well below the deep p-type well, wherein the deep p-type well vertically separates the deep n-type well from the first SCR and the second SCR.

### Embodiment 16:

The structure of embodiment 15, wherein the deep p-type well and the deep n-type well each define floating semiconductor regions within the structure.

### Embodiment 17:

The structure of one of embodiments 1 to 16, further comprising an n-type deep well over the substrate, wherein the deep p-type well is over the n-type deep well, a P+ terminal on the first n-type well and coupled to an input/output (I/O) node, a first N+ terminal on one of the pair of second n-type wells and coupled to ground; and a second N+ terminal on the other of the pair of second n-type wells and coupled to a voltage supply, wherein the deep p-type well, the deep n-type well, the first n-type well, and the pair of p-type wells each define floating semiconductor regions within the structure.

### Embodiment 18:

A structure comprising: an n-type deep well over a substrate; a p-type deep well over the n-type deep well; a first n-type well over the p-type deep well; a P+ terminal on the first n-type well and coupled to an input/output (I/O) node, a pair of p-type wells over the p-type deep well and adjacent opposite horizontal ends of the first n-type well; a pair of second n-type wells over the p-type deep well and each adjacent one of the pair of p-type wells, such that each p-type well is horizontally between the first n-type well and one of the second n-type wells; a first N+ terminal on one of the pair of second n-type wells and coupled to ground; and a second N+ terminal on the other of the pair of second n-type wells and coupled to a voltage supply, wherein the deep p-type well, the deep n-type well, the first n-type well, and the pair of p-type wells each define floating semiconductor regions within the structure.

### Embodiment 19:

The structure of embodiment 17 or 18, further comprising a pair of trench isolation (TI) regions each over a corresponding one of the pair of p-type wells, wherein the P+ terminal is horizontally between the pair of isolation regions.

### Embodiment 20:

The structure of embodiment 17 to 19, wherein a current pathway between the I/O terminal and the first N+ terminal defines a first semiconductor controlled rectifier (SCR), and a current pathway between the I/O terminal and the second N+ terminal defines a second SCR, and the first n-type well is shared between the first SCR and the second SCR.

### Embodiment 21:

The structure of embodiment 20, wherein the first SCR and the second SCR are of opposite polarity during operation.

### Embodiment 22:

The structure of one of embodiments 17 to 21, wherein the deep p-type well vertically separates the deep n-type well from the first n-type well, the pair of p-type wells, and the pair of second n-type wells.

### Embodiment 23:

The structure of one of embodiments 5 and 9 to 16, wherein the first SCR and the second SCR are of opposite polarity during operation.

At least in the above described embodiments 1 to 23, the expressions "n-type deep well" and "deep n-type well" are to be considered synonymous and the expressions "p-type deep well" and "deep p-type well" are to be considered synonymous.

## Claims

1. A structure comprising:
a p-type deep well over a substrate;
a first n-type well over the p-type deep well;
a pair of p-type wells over the p-type deep well and adjacent opposite horizontal ends of the first n-type well; and
a pair of second n-type wells over the p-type deep well and each adjacent one of the pair of p-type wells, such that each p-type well is horizontally between the first n-type well and one of the second n-type wells.

2. The structure of claim 1, wherein the n-type well and/or the pair of p-type wells define floating semiconductor regions within the structure.

3. The structure of claim 1 or 2, further comprising an n-type deep well below the p-type deep well, wherein the p-type deep well vertically separates the n-type deep well from the first n-type well, the pair of p-type wells, and the pair of second n-type wells.

4. The structure of claim 3, wherein the p-type deep well and the n-type deep well each define floating semiconductor regions within the structure.

5. The structure of one of claims 1 to 4, further comprising a P+ terminal on the first n-type well, the P+ terminal being coupled to an input/output (I/O) terminal, and/or wherein the first n-type well defines a floating well beneath the P+ terminal.

6. The structure of claim 5, further comprising a pair of trench isolation (TI) regions each over a corresponding one of the pair of p-type wells, wherein the P+ terminal is horizontally between the pair of isolation regions.

7. The structure of claim 5 or 6, further comprising a first N+ terminal coupled to ground and on one of the pair of second n-type wells and a second N+ terminal coupled to a voltage supply and on the other of the pair of second n-type wells.

8. The structure of claim 7, wherein a current pathway between the I/O terminal and the first N+ terminal defines a first semiconductor controlled rectifier (SCR), and a current pathway between the I/O terminal and the second N+ terminal defines a second SCR, and the first n-type well is shared between the first SCR and the second SCR.

9. The structure of one of claims 1 to 8, comprising a first semiconductor-controlled rectifier (SCR) and a second SCR, each being formed over the substrate,
wherein the pair of p-type wells comprises a first p-type well and a second p-type well,
wherein the pair of second n-type wells comprises a second n-type well and a third n-type well,
wherein the first SCR comprises a first set of alternatingly doped wells to define a first N-P-N junction over the substrate, wherein the first set of alternatingly doped wells comprises the first n-type well within a floating well region, the second n-type well coupled to ground, and the first p-type well therebetween; and
wherein the second SCR comprises a second set of alternatingly doped wells to define a second N-P-N junction over the substrate, wherein the second set of alternatingly doped wells comprises the first n-type well within the floating well region, the third n-type well coupled to a voltage supply, and the second p-type well therebetween,
wherein the first n-type well is shared between the first SCR and the second SCR.

10. The structure of claim 8 or 9, wherein the first SCR and the second SCR are of opposite polarity during operation.

11. The structure of one of claims 8 to 10, further comprising:
a p-type deep well below the first SCR and the second SCR; and
an n-type deep well below the p-type deep well, wherein the p-type deep well vertically separates the n-type deep well from the first SCR and the second SCR.

12. The structure of claim 11, wherein the p-type deep well, the n-type deep well, the first n-type well, and the pair of p-type wells each define floating semiconductor regions within the structure.

13. The structure of claim 11 or 12, wherein the p-type deep well vertically separates the n-type deep well from the first n-type well, the pair of p-type wells, and the pair of second n-type wells.
